# EUROPEAN PATENT SPECIFICATION

(11) **EP 1 746 671 B1**
(45) Date of publication and mention of the grant of the patent: **04.09.2019**
(21) Application number: 06014262.7
(22) Date of filing: 10.07.2006
(51) Int. Cl.: H01L 51/56, H01L 51/52

(54) **Surface-selective deposition of organic thin films**
Oberflächenselektive Ablagerung von organischen dünnen Schichten
Dépôt sélectif en surface de couche minces organiques

(30) Priority: 19.07.2005 US 185216
(43) Date of publication of application: 24.01.2007
(73) Proprietor: OSRAM OLED GmbH, 93049 Regensburg (DE)
(72) Inventor: Allemand, Pierre-Marc, San Jose, CA 95110 (US)
(74) Representative: Epping - Hermann - Fischer

(56) References cited:
- US-A1- 2004 131 883
- MENG H; PEREPICHKA D F; BENDIKOV M; WUDL F; PAN G Z; YU W; DONG W; BROWN S: "Solid-State Synthesis of a Conducting Polythiophene via an Unprecedented Heterocyclic Coupling Reaction" JOURNAL OF THE AMERICAN CHEMICAL SOCIETY, vol. 125, 11 December 2003 (2003-12-11), pages 15151-15162, XP002579326
- MENG H ET AL: "Facile Solid-State Synthesis of Highly Conducting Poly(ethylenedioxythiophene)" ANGEWANDTE CHEMIE. INTERNATIONAL EDITION, WILEY VCH VERLAG, WEINHEIM LNKD- DOI:10.1002/ANIE.200390181, vol. 42, no. 6, 1 January 2003 (2003-01-01), pages 658-661, XP002344157 ISSN: 1433-7851
- KIM J ET AL: "The preparation and characterisitics of conductive poly(3,4-ethylenedioxythiophene) thin films by vapor-phase polymerization" SYNTHETIC METALS, ELSEVIER SEQUOIA, LAUSANNE, CH LNKD- DOI:10.1016/S0379-6779(03)00202-9, vol. 139, 5 September 2003 (2003-09-05), pages 485-489, XP002499640 ISSN: 0379-6779
- WINTHER-JENSEN B; WEST K: "Vapor-phase polymerization of 3,4-ethylenedioxythiophene: A route to highly conducting polymer surface layers" MACROMOLECULES, vol. 37, 5 December 2004 (2004-12-05), pages 4538-4543, XP002579327

## Description

### BACKGROUND

### 1. Field of the Invention

This invention relates generally to the art of thin film device processing and fabrication. More specifically, the invention relates to the fabrication of organic thin film devices.

### 2. Related Art

Examples of other elements/devices using organic materials include organic light emitting diode (OLED) devices, organic solar cells, organic transistors, organic detectors, and organic lasers. There are also a number of bio-technology applications such as biochips for DNA recognition, combinatorial synthesis, etc. which utilize organic materials.

An OLED is typically comprised of two or more thin at least partially conducting organic layers (e.g., an electrically conducting hole transporting polymer layer (HTLs) and an emissive polymer layer where the emissive polymer layer emits light) which are sandwiched between an anode and a cathode. Under an applied forward potential, the anode injects holes into the conducting polymer layer, while the cathode injects electrons into the emissive polymer layer. The injected holes and electrons each migrate toward the oppositely charged electrode and recombine to form an exciton in the emissive polymer layer. The exciton relaxes to a lower energy state by emission of radiation and in process, emits light.

Other organic electronic devices, such as organic transistors and organic sensors will also typically contain a conducting organic (polymer) layer and other organic layers which are thin films formed by selective or non-selective deposition techniques. Organic materials are believed to hold tremendous opportunities for the low cost manufacturing of electronic devices such as OLEDs and organic transistors, since it is expected that the fabrication processes of such microcircuits are much less complex compared with conventional silicon technology because low-temperature deposition and solution processing can replace the more complicated processes involved in conventional silicon technology. However these fabrication processes for organic electronics are not mature yet. For example, SMOLEDs (small molecule OLEDs) manufacturing usually uses PVD, but shadow masks with limited resolution are necessary to deposit the organic materials in a defined pattern. PLEDs (Polymer LEDs) manufacturing usually uses solution processing (spin/dip/jet casting), but surface tension effects on photoresist banks (pile-up effects) and further patterning (vias, glue-line) are sometimes problematic. Furthermore, the lateral resistivity of some layers has to be high enough to prevent cross-talk in passive-matrix type displays made from PLEDs. Document US2004/0131883 A1 discloses a method for spin-coating PEDOT/PSS on top of an ITO electrode to fabricate an OLED device.

It would be desirable to fabricate organic thin films and devices and overcome these limitations.

### BRIEF DESCRIPTION OF THE DRAWINGS

FIG. 1 illustrates the polymerization reaction of DBEDOT into PEDOTB.
FIG. 2 illustrates a flowchart of fabricating a polymeric PEDOT film in an OLED device in accordance with at least one embodiment of the invention.
FIG. 3 illustrates the results of selective PEDOTB film fabrication according to one or more embodiments of the invention.
FIG. 4 shows a cross-sectional view of an embodiment of an organic electronic device 405 according to the invention.

### DETAILED DESCRIPTION OF THE INVENTION

The invention refers to a method of fabricating an organic electronic device and an organic electronic device according to the independent claims.

In accordance with the invention, a thin film of PEDOTB, [PEDOTⁿ⁺;nBr³⁻] (where PEDOT is poly (3,4-ethylenedioxy) thiophene) is fabricated on a device by the following process. A thin film of PEDOTB is fabricated on a device by moderate heating of a small amount of 2,5-dibromo-3,4-ethylenedioxythiophene (DBEDOT) monomer powder in a chamber in the presence of a patterned substrate. The DBEDOT monomer evaporates in the chamber, and forms a deposit of PEDOTB only on certain areas of the substrate, particularly, in the case of an OLED, the ITO (Indium Tin Oxide) regions. One explanation for the mechanism by which this occurs is that 1) the DBEDOT monomer powder evaporates and re-deposits onto the entire substrate, then 2) only the monomer deposited on the ITO surfaces undergoes a solid-state polymerization yielding a film of PEDOTB and 3) the monomer deposited of non-ITO surfaces simply re-evaporates away without polymerizing. An alternate explanation may be that the DBEDOT monomer evaporates and re-deposits (or condenses) only onto ITO surfaces and spontaneously polymerizes while depositing.

The initial DBEDOT monomer evaporation can be performed non-selectively over the entire device without the use of a shadow mask such as by vapor deposition. During the evaporation, a portion of the DBEDOT monomer polymerizes in selected regions of the device depending upon the material constituency of the region. In certain regions, the monomer mostly evaporates without being polymerized, and hence does not remain on the surface or remains only negligibly on the surface of these regions. This selective deposition enables PEDOTB to be fabricated in desirable regions of the device without the necessity of a shadow mask.

In one embodiment of the invention where the device being fabricated is an OLED having ITO (Indium Tin Oxide) as its anode, the vapor phase deposition and polymerization of the DBEDOT monomer into PEDOTB occurs primarily on the surface of ITO regions of the device. The ITO regions of the device, as discussed below, are the active light emitting portions ("pixels") of the device, and hence, this is desirable. Photo-resist, glass and other regions of the OLED show only negligible, if any at all, traces of polymerized PEDOTB. In such embodiments, the DBEDOT was evaporated at temperatures around 80C and at normal atmospheric pressure.

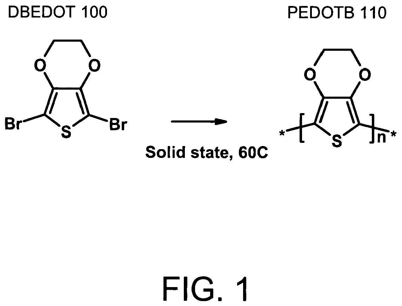

FIG. 1 illustrates the polymerization reaction of DBEDOT into PEDOTB. DBEDOT 100 undergoes a unique solid-state polymerization reaction when heated below its melting point as has been recently shown in various literature (see Fred Wudl et al, JACS 2003, 125, 15151; and McCulloch et al, J.Chem.Mat. 2003, 13, 2075). DBEDOT 100 polymerizes into PEDOTB 110, but evidently only in solid state form. The reaction can occur at temperatures at or around 60 C or greater and at normal atmospheric pressures.

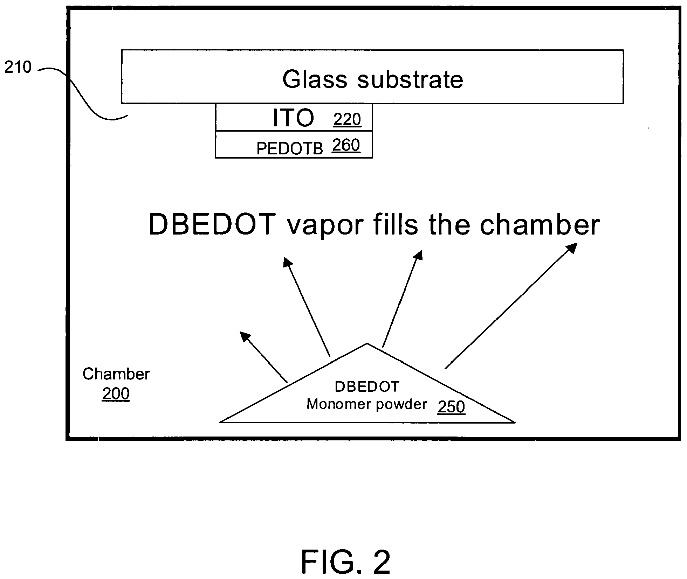

FIG. 2 illustrates the process of fabricating a polymeric PEDOT film in an OLED device in accordance with at least one embodiment of the invention. The OLED device 210 with a substrate (typically glass) and (an anode) ITO 220 is placed in a chamber 200. DBEDOT monomer powder (or granules) 250 of a particular quantity is also placed in chamber 200. The chamber is heated to 60 C. This causes the DBEDOT monomer powder 250 to undergo vaporization and deposit on the exposed surfaces of OLED device 210 including, but not limited to, ITO 220. On selected surfaces, the DBEDOT 250 in vapor phase contacts these surfaces and undergoes polymerization into PEDOTB 260. On other surfaces, there is little or no polymerization and rather the DBEDOT is simply evaporated away failing to form a sufficient film or failing to even deposit. The deposition/polymerization occurs only on select surfaces of OLED device 210 and not on all surfaces. The selected surfaces being ITO.

The vapor deposition of the DBEDOT monomer can occur at normal atmospheric pressures and at temperatures of 60 C or greater. It was found, for instance, that a temperature of 80 C provided adequate evaporation. The polymerized PEDOTB 260 resulting from this process was found to form primarily on surfaces ITO 220 and not on photoresist (not shown) or the substrate, for instance. There is some polymerization on certain other metal surfaces such as copper, and sometimes in a more pronounced fashion than with ITO. The result is to form a PEDOTB film 260 on the ITO 220 and not elsewhere on the device 210 surfaces. This would be desirable in OLED and other organic electronic devices with a pixelated or patterned anode layer and multiple other surfaces. It would make fabrication of PEDOT based films much more cost-efficient since there is no shadow mask or other selective deposition technique required. The amount of DBEDOT that is evaporated will govern the thickness of the resulting PEDOTB film, and sometimes whether there is any polymerization at all.

This vapor deposition can be done with or without a shadow mask. In particular, with the appropriate choice of existing surface materials on the device, a shadow mask is not needed as the polymerization occurs to leave a film only on the exposed anode, as described below. However, a shadow mask having a different pattern than the ITO pattern can be advantageously used to create more complex structures. The substrate may also contain metallization lines which are conductive pathways within and to the device. There may also be a photoresist on the substrate and/or anode which is utilized in polymer film deposition and the like.

It is believed that ITO and certain metal surfaces may act as catalysts to the polymerization of DBEDOT into PEDOTB. The rate of monomer deposition and/or polymerization on these surfaces is greater than on other surfaces, and thus the deposition/polymerization of material is leaving more material on these surfaces. When contacting DBEDOT monomer vapor on various surfaces simultaneously, the relative amounts of PEDOTB polymer remaining on these surfaces after evaporation was as follows. In cases where there was photoresist, copper, ITO and glass, simultaneous deposition and subsequent evaporation of DBEDOT yielded the most PEDOTB film on copper, followed by some on ITO and none or almost none on glass. In cases where there was photoresist, chromium, ITO and glass, simultaneous deposition and subsequent evaporation of DBEDOT yielded the most PEDOTB film on ITO, followed by very minimal amounts on chromium and none or almost none on photoresist and glass.

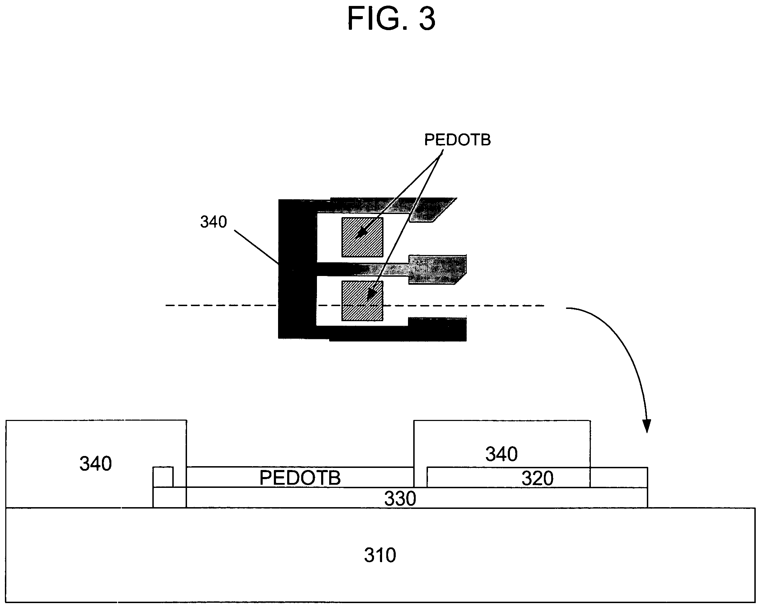

FIG. 3 illustrates the results of selective PEDOTB film fabrication according to one or more embodiments of the invention. DBEDOT monomer was vapor deposited on a device 300 having surfaces 310, 320 and 330. Both a top view and cross-section view of the same device are shown. Surface 310 is the glass substrate of the device. Surface 320 is CrAlCr (chromium-aluminum-chromium) metalization lines. Surface 330 is ITO. Surface 340 is photoresist. The DBEDOT monomer vapor contacted all of the surfaces 310, 320 and 330 in simultaneous fashion. No shadow mask or selective deposition technique was used. Polymerization of the deposited DBEDOT into PEDOTB is shown in the shaded area and thus, it can be observed that polymerization/deposition occurred on only the surface 330 of ITO. The deposited DBEDOT, if any, was evaporated away without any (or very miniscule amounts) remaining as polymerized PEDOTB on the surfaces 310 and 320 and 340. Thus, a polymeric PEDOT film was fabricated using a vapor deposition process and without any additional processing steps or masks.

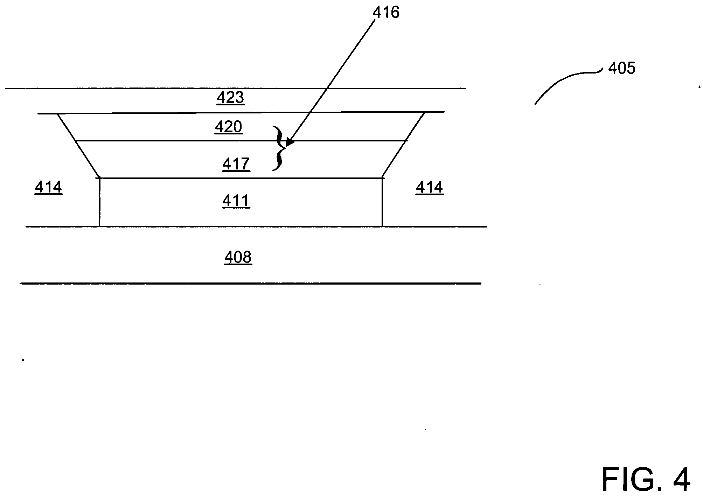

FIG. 4 shows a cross-sectional view of an embodiment of an organic electronic device 405 according to the invention. As shown in FIG. 4, the organic electronic device 405 includes a first electrode 411 on a substrate 408. As used within the specification and the claims, the term "on" includes when layers are in physical contact and when layers are separated by one or more intervening layers. The first electrode 411 may be patterned for pixelated applications or unpatterned for backlight applications. If the electronic device 405 is a transistor, then the first electrode may be, for example, the source and drain contacts of that transistor. A photo-resist material is deposited on the first electrode 411 and patterned to form a bank structure 414 having an aperture that exposes the first electrode 411. The aperture may be a pocket (e.g., a pixel of an OLED display) or a line. The bank structure 414 is an insulating structure that electrically isolates one pocket from another pocket or one line from another line. The bank structure 414 is optional and may not be desirable or necessary depending upon device parameters and processing techniques.

One or more organic materials is deposited into the aperture to form one or more organic layers of an organic stack 416. The organic stack 416 is on the first electrode 411. The organic stack 416 includes a hole transporting (conducting polymer) layer ("HTL") 417 and active electronic layer 420. The electronic device 405 also includes a second electrode 423 on the organic stack 416. Other layers than that shown in FIG. 4 may also be added including insulating layers between the first electrode 411 and the organic stack 416, and/or between the organic stack 416 and the second electrode 423, encapsulation layers, getter layers, barrier layers and the like. Some of these layers, in accordance with the invention, are described in greater detail below.

### Substrate 408:

The substrate 408 can be any material that can support the organic and metallic layers on it. The substrate 408 can be transparent or opaque (e.g., the opaque substrate is used in top-emitting devices). By modifying or filtering the wavelength of light which can pass through the substrate 408, the color of light emitted by the device can be changed. The substrate 408 can be comprised of glass, quartz, silicon, plastic, or stainless steel; preferably, the substrate 408 is comprised of thin, flexible glass. The preferred thickness of the substrate 408 depends on the material used and on the application of the device. The substrate 408 can be in the form of a sheet or continuous film. The continuous film can be used, for example, for roll-to-roll manufacturing processes which are particularly suited for plastic, metal, and metalized plastic foils. The substrate can also have transistors or other switching elements built in to control the operation of the device.

### First Electrode 411:

In one configuration, the first electrode 411 functions as an anode (the anode is a conductive layer which serves as a hole-injecting layer and which comprises a material with work function greater than about 4.5 eV). Typical anode materials include metals (such as platinum, gold, palladium, indium, and the like); metal oxides (such as lead oxide, tin oxide, ITO, and the like); graphite; doped inorganic semiconductors (such as silicon, germanium, gallium arsenide, and the like); and doped conducting polymers (such as polyaniline, polypyrrole, polythiophene, and the like).

The first electrode 411 can be transparent, semitransparent, or opaque to the wavelength of light generated within the device. The thickness of the first electrode 411 is from about 10 nm to about 1000 nm, preferably, from about 50 nm to about 200 nm, and more preferably, is about 100 nm. The first electrode layer 411 can typically be fabricated using any of the techniques known in the art for deposition of thin films, including, for example, vacuum evaporation, sputtering, electron beam deposition, or chemical vapor deposition.

### Bank Structure 414:

The bank structure 414 is made of a photo-resist material such as, for example, polyimides or polysiloxanes. The photo-resist material can be either positive photo-resist material or negative photo-resist material. The bank structure 414 is an insulating structure that electrically isolates one pocket from another pocket or one line from another line. The bank structure 414 has an aperture 415 that exposes the first electrode 411. The aperture 415 may represent a pocket or a line. The bank structure 414 is patterned by applying lithography techniques to the photo-resist material, or by using screen printing or flexo-printing to deposit the bank material in the desired pattern. As shown in FIG. 4, the bank structure 414 can have, for example, a trapezoidal configuration in which the angle between the side wall of the bank structure 414 and the first electrode 411 is an obtuse angle.

### HTL 417:

The HTL 417 has a much higher hole mobility than electron mobility and is used to effectively transport holes from the first electrode 411 to the active electronic layer 420. The HTL 417 has a thickness from about 5nm to about 1000 nm, preferably from about 20nm to about 500 nm, and more preferably from about 50 to about 250 nm.

The HTL 417 functions as: (1) a buffer to provide a good bond to the substrate; and/or (2) a hole injection layer to promote hole injection; and /or (3) a hole transport layer to promote hole transport. As mentioned above, in accordance with the invention, a DBEDOT or similar monomer is vapor deposited on the device 405. The DBEDOT monomer may thus be deposited on the exposed portions of first electrode 411 and the substrate 408 and bank structure 414. In accordance with the invention, the deposited DBEDOT monomer will polymerize into PEDOTB film above the first electrode 411. This polymerized film constitutes the HTL 417. The polymerized film, in the configuration shown will form into the aperture 415 and on the first electrode 411. In accordance with the invention, DBEDOT monomer vapor when contacting exposed surfaces of the substrate 408 and the bank structure 414 can be evaporated away without any polymerized PEDOTB remaining on the exposed substrate. The desired thickness of the HTL 417 can be attained by depositing an appropriate amount of DBEDOT monomer.

### Active Electronic Layer 420:

Active electronic layer 420 can include one or more layers. Active electronic layer 420 includes an active electronic material. Active electronic materials can include a single active electronic material, a combination of active electronic materials, or multiple layers of single or combined active electronic materials. Preferably, at least one active electronic material is organic.

For organic LEDs (OLEDs), the active electronic layer 316 contains at least one organic material that emits light. These organic light emitting materials generally fall into two categories. The first category of OLEDs, referred to as polymeric light emitting diodes, or PLEDs, utilize polymers as part of active electronic layer 420. The polymers may be organic or organometallic in nature. As used herein, the term organic also includes organometallic materials. Preferably, these polymers are solvated in an organic solvent, such as toluene or xylene, and spun (spin-coated) onto the device, although other methods are possible. Devices utilizing polymeric active electronic materials in active electronic layer 316 are especially preferred. In addition to materials that emit light, active electronic layer 420 may include a light responsive material that changes its electrical properties in response to the absorption of light. Light responsive materials are often used in detectors and solar panels that convert light energy to electrical energy.

If the organic electronic device is an OLED or an organic laser, then the organic polymers are electroluminescent ("EL") polymers that emit light. The light emitting organic polymers can be, for example, EL polymers having a conjugated repeating unit, in particular EL polymers in which neighboring repeating units are bonded in a conjugated manner, such as polythiophenes, polyphenylenes, polythiophenevinylenes, or poly-p-phenylenevinylenes or their families, copolymers, derivatives, or mixtures thereof. More specifically, the organic polymers can be, for example: polyfluorenes; poly-p-phenylenevinylenes that emit white, red, blue, yellow, or green light and are 2-, or 2, 5- substituted poly-p-pheneylenevinylenes; polyspiro polymers; or their families, copolymers, derivatives, or mixtures thereof.

If the organic electronic device is an organic solar cell or an organic light detector, then the organic polymers are light responsive material that changes its electrical properties in response to the absorption of light. The light responsive material converts light energy to electrical energy.

If the organic electronic device is an organic transistor, then the organic polymers can be, for example, polymeric and/or oligomeric semiconductors. The polymeric semiconductor can comprise, for example, polythiophene, poly(3-alkyl)thiophene, polythienylenevinylene, poly(para-phenylenevinylene), or polyfluorenes or their families, copolymers, derivatives, or mixtures thereof.

In addition to polymers, smaller organic molecules that emit by fluorescence or by phosphorescence can serve as a light emitting material residing in active electronic layer 420. Unlike polymeric materials that are applied as solutions or suspensions, small-molecule light emitting materials are preferably deposited through evaporative, sublimation, or organic vapor phase deposition methods. Combinations of PLED materials and smaller organic molecules can also serve as active electronic layer. For example, a PLED may be chemically derivatized with a small organic molecule or simply mixed with a small organic molecule to form active electronic layer 420.

In addition to active electronic materials that emit light, active electronic layer 420 can include a material capable of charge transport. Charge transport materials include polymers or small molecules that can transport charge carriers. For example, organic materials such as polythiophene, derivatized polythiophene, oligomeric polythiophene, derivatized oligomeric polythiophene, pentacene, compositions including C60, and compositions including derivatized C60 may be used. Active electronic layer 420 may also include semiconductors, such as silicon or gallium arsenide.

### Second Electrode (423)

In one embodiment, second electrode 423 functions as a cathode when an electric potential is applied across the first electrode 411 and second electrode 423. In this embodiment, when an electric potential is applied across the first electrode 411, which serves as the anode, and second electrode 423, which serves as the cathode, photons are released from active electronic layer 420 that pass through first electrode 411 and substrate 408.

While many materials, which can function as a cathode, are known to those of skill in the art, most preferably a composition that includes aluminum, indium, silver, gold, magnesium, calcium, and barium, or combinations thereof, or alloys thereof, is utilized.

Preferably, the thickness of second electrode 423 is from about 10 to about 1000 nanometers (nm), more preferably from about 50 to about 500 nm, and most preferably from about 100 to about 300 nm. While many methods are known to those of ordinary skill in the art by which the first electrode material may be deposited, vacuum deposition methods, such as physical vapor deposition (PVD) are preferred. Other layers (not shown) such as a barrier layer and getter layer may also be used to protect the electronic device. Such layers are well-known in the art and are not specifically discussed herein. Also, there may be metalization lines, conductive pathways, contacts and the like which connect with various parts of the OLED device especially when the device is mass manufactured or intended to be part of a larger system or display.

While the embodiments of the invention are illustrated in which it is primarily incorporated within an OLED device, almost any type of organic electronic device that uses film of hole transporting material such as PEDOT may be potential applications for these embodiments. In particular, present invention may also be utilized in a solar cell, a transistor, a phototransistor, a laser, a photo-detector, or an opto-coupler. It can also be used in biological applications such as bio-sensors or chemical applications such as applications in combinatorial synthesis etc. The OLED device described earlier can be used within displays in applications such as, for example, computer displays, information displays in vehicles, television monitors, telephones, printers, and illuminated signs.

## Claims

1. A method of fabricating an organic electronic device (210,300,405), **characterized in that** said method comprises:
fabricating a lower electrode layer (220,330,411) upon a substrate (310,408) of said device, wherein said lower electrode layer (220,330,411) having a top exposed surface, wherein said lower electrode layer (220,330,411) comprises indium tin oxide, wherein said substrate (310,408) having a surface;
placing said device in a chamber (200);
placing a hole transporting monomer material (250) into said chamber (200);
vapor depositing said hole transporting monomer (250) onto said device, and polymerizing at least a portion of said hole transporting monomer (250), wherein the step of depositing and polymerizing is processed selectively on said top exposed surface of said lower electrode layer (220,330,411) wherein said polymerization forms a hole transporting layer (260,417) over said top exposed surface of said lower electrode layer (220,330,411).

2. A method according to claim 1 wherein said hole transporting monomer (250) is dibromo(3,4-ethylenedioxy)thiophene.

3. A method according to any of claims 1 or 2 wherein said hole transporting layer (260,417) comprises poly(3,4-ethylenedioxy)thiophene.

4. A method according to any of the claims 1 to 3 wherein said substrate (310,408) comprises glass.

5. A method according to any of the claims 1 to 4 wherein said organic electronic device (210,300,405) is an organic light emitting diode (OLED) device.

6. A method according to claim 5 further comprising:
fabricating an emissive layer (420) above said hole transporting layer (260,417), said emissive layer (420) emitting light upon charge recombination.

7. A method according to any of the claims 1 to 6 wherein said vapor depositing is conducted at above 60 °C.

8. A method according to any of the claims 1 to 7 wherein said hole transporting layer (260,417) is not deposited on the substrate (310,408).

9. A method according to any of the claims 1 to 8 wherein said top exposed surface of said lower electrode layer (220,330,411) is a catalyst to the polymerization.

10. A method according to any of the claims 1 to 9 wherein said hole transporting monomer (250) is non-selectively deposited over the entire device and wherein at least a portion of said deposited hole transporting monomer (250) polymerizes only on said top exposed surface of said lower electrode layer (220,330,411).

11. A method according to any of the claims 1 to 10 wherein a shadow mask is not used by said vapor depositing.

12. An organic electronic device (210,300,405) **characterized in that** the device comprises:
a lower electrode layer (220,330,411) comprising indium tin oxide; and
a hole transporting layer (260,417) comprising a polymer, said hole transporting layer (260,417) fabricated by vapor depositing a hole transporting monomer (250) onto said device, wherein the polymerized hole transporting layer (260,417) is formed primarily on said top exposed surface of said lower electrode layer (220,330,411) and not on the surface of the substrate (310,408) and/or elsewhere on the surfaces of said device.

13. The device (210,300,405) according to claim 12 wherein said hole transporting layer (260,417) is formed from hole transporting monomers (250), wherein said hole transporting monomer (250) is dibromo(3,4-ethylenedioxy)thiophene.

14. The device (210,300,405) according to any of the claims 12 or 13 wherein said hole transporting layer (260,417) comprises poly(3,4-ethylenedioxy)thiophene.

15. The device (210,300,405) according to any of the claims 12 to 14 wherein said substrate (310,408) comprises glass.

16. The device (210,300,405) according to any of the claims 12 to 15 wherein said organic electronic device is an organic light emitting diode (OLED) device.

17. The device (210,300,405) according to claim 16 further comprising:
an emissive layer (420) above said hole transporting layer (260,417), said emissive layer (420) emitting light upon charge recombination.

## Patentansprüche

1. Verfahren zur Herstellung einer organischen elektronischen Vorrichtung (210,300,405), **dadurch gekennzeichnet, dass** das Verfahren umfasst:
Herstellen einer unteren Elektrodenschicht (220,330,411) auf einem Substrat (310,408) der Vorrichtung, wobei die untere Elektrodenschicht (220,330,411) eine obere freiliegende Oberfläche aufweist, wobei die untere Elektrodenschicht (220,330,411) Indiumzinnoxid umfasst, wobei das Substrat (310,408) eine Oberfläche aufweist;
Platzieren der Vorrichtung in einer Kammer (200);
Platzieren eines Lochtransport Monomermaterials (250) in die Kammer (200);
Dampfabscheidung des Lochtransportmonomers (250) auf die Vorrichtung und Polymerisierung mindestens eines Teils des Lochtransportmonomers (250), wobei der Schritt des Abscheidens und Polymerisierens selektiv auf der oberen freiliegenden Oberfläche der unteren Elektrodenschicht (220,330,411) durchgeführt wird, wobei die Polymerisierung eine Lochtransportschicht (260,417) über der oberen freiliegenden Oberfläche der unteren Elektrodenschicht (220,330,411) bildet.

2. Verfahren nach Anspruch 1, wobei das Lochtransportmonomer (250) Dibrom(3,4-ethylendioxy)thiophen ist.

3. Verfahren nach einem der Ansprüche 1 oder 2, worbei die Lochtransportschicht (260,417) Poly(3,4-ethylendioxy)thiophen umfasst.

4. Verfahren nach einem der Ansprüche 1 bis 3, wobei das Substrat (310,408) Glas umfasst.

5. Verfahren nach einem der Ansprüche 1 bis 4, wobei die organische elektronische Vorrichtung (210,300,405) eine organische lichtemittierende Dioden-(OLED)-Vorrichtung ist.

6. Verfahren nach Anspruch 5, ferner umfassend:
Herstellen einer emittierenden Schicht (420) über der Lochtransportschicht (260,417), wobei die emittierende Schicht (420) bei Ladungsrekombination Licht emittiert.

7. Verfahren nach einem der Ansprüche 1 bis 6, wobei die Dampfabscheidung bei über 60 °C durchgeführt wird.

8. Verfahren nach einem der Ansprüche 1 bis 7, wobei die Lochtransportschicht (260,417) nicht auf dem Substrat (310,408) abgeschieden wird.

9. Verfahren nach einem der Ansprüche 1 bis 8, wobei die obere freiliegende Oberfläche der unteren Elektrodenschicht (220,330,411) ein Katalysator für die Polymerisierung ist.

10. Verfahren nach einem der Ansprüche 1 bis 9, wobei das Lochtransportmonomer (250) nicht-selektiv über die gesamte Vorrichtung abgeschieden wird und wobei mindestens ein Teil des abgeschiedenen Lochtransportmonomers (250) nur auf der oberen freiliegenden Oberfläche der unteren Elektrodenschicht (220,330,411) polymerisiert.

11. Verfahren nach einem der Ansprüche 1 bis 10, wobei eine Schattenmaske nicht durch die Dampfabscheidung verwendet wird.

12. Organische elektronische Vorrichtung (210,300,405), **dadurch gekennzeichnet, dass** die Vorrichtung umfasst:
eine untere Elektrodenschicht (220,330,411), die Indiumzinnoxid umfasst; und
eine Lochtransportschicht (260,417), die ein Polymer umfasst, wobei die Lochtransportschicht (260,417) durch Dampfabscheidung eines Lochtransportmonomers (250) auf die Vorrichtung hergestellt wird, wobei die polymerisierte Lochtransportschicht (260,417) hauptsächlich auf der oberen freiliegenden Oberfläche der unteren Elektrodenschicht (220,330,411) und nicht auf der Oberfläche des Substrats (310,408) und/oder an anderer Stelle auf den Oberflächen der Vorrichtung ausgebildet ist.

13. Vorrichtung (210,300,405) nach Anspruch 12, wobei die Lochtransportschicht (260,417) aus Lochtransportmonomeren (250) gebildet ist, wobei das Lochtransportmonomer (250) Dibrom(3,4-ethylendioxy)thiophen ist.

14. Vorrichtung (210,300,405) nach einem der Ansprüche 12 oder 13, wobei die Lochtransportschicht (260,417) Poly(3,4-ethylendioxy)thiophen umfasst.

15. Vorrichtung (210,300,405) nach einem der Ansprüche 12 bis 14, wobei das Substrat (310,408) Glas umfasst.

16. Vorrichtung (210,300,405) nach einem der Ansprüche 12 bis 15, wobei die organische elektronische Vorrichtung eine organische lichtemittierende Dioden (OLED)-Vorrichtung ist.

17. Vorrichtung (210,300,405) nach Anspruch 16 ferner umfassend:
eine emittierende Schicht (420) über der Lochtransportschicht (260,417), wobei die emittierende Schicht (420) bei Ladungsrekombination Licht emittiert.

## Revendications

1. Procédé de fabrication d'un dispositif électronique organique (210, 300, 405), **caractérisé en ce que** ledit procédé comprend :
la fabrication d'une couche d'électrode inférieure (220, 330, 411) sur un substrat (310, 408) dudit dispositif, ladite couche d'électrode inférieure (220, 330, 411) présentant une surface supérieure exposée, ladite couche d'électrode inférieure (220, 330, 411) comportant de l'oxyde d'indium-étain, ledit substrat (310, 408) présentant une surface ;
le placement dudit dispositif dans une chambre (200) ;
le placement d'un matériau monomère de transport de trous (250) dans ladite chambre (200) ;
le dépôt en phase vapeur du monomère de transport de trous (250) sur le dispositif et la polymérisation d'au moins une partie dudit monomère de transport de trous (250), l'étape de dépôt et de polymérisation étant traitée sélectivement sur la surface supérieure exposée de la couche d'électrode inférieure (220, 330, 411), la polymérisation formant une couche de transport de trous (260, 417) sur la surface supérieure exposée de la couche d'électrode inférieure (220, 330, 411).

2. Procédé selon la revendication 1, dans lequel le monomère de transport de trous (250) est du dibromo(3,4-éthylènedioxy)thiophène.

3. Procédé selon l'une des revendications 1 ou 2, dans lequel la couche de transport de trous (260, 417) comprend du poly(3,4-éthylènedioxy) thiophène.

4. Procédé selon l'une des revendications 1 à 3, dans lequel le substrat (310, 408) comprend du verre.

5. Procédé selon l'une des revendications 1 à 4, dans lequel le dispositif électronique organique (210, 300, 405) est un dispositif à diode électroluminescente organique (OLED).

6. Procédé selon la revendication 5 comprenant en outre :
la fabrication d'une couche émissive (420) au-dessus de la couche de transport de trous (260, 417), ladite couche émissive (420) émettant de la lumière par recombinaison de charges.

7. Procédé selon l'une des revendications 1 à 6, dans lequel le dépôt en phase vapeur est effectué à une température supérieure à 60 °C.

8. Procédé selon l'une des revendications 1 à 7, dans lequel la couche de transport de trous (260, 417) n'est pas déposée sur le substrat (310, 408).

9. Procédé selon l'une des revendications 1 à 8, dans lequel la surface supérieure exposée de la couche d'électrode inférieure (220, 330, 411) est un catalyseur pour la polymérisation.

10. Procédé selon l'une des revendications 1 à 9, dans lequel le monomère de transport de trous (250) est déposé de manière non sélective sur l'ensemble du dispositif et dans lequel au moins une partie dudit monomère de transport de trous déposé (250) polymérise uniquement sur la surface supérieure exposée de la couche d'électrode inférieure (220, 330, 411).

11. Procédé selon l'une des revendications 1 à 10, dans lequel le dépôt en phase vapeur n'utilise pas de masque d'ombre.

12. Dispositif électronique organique (210, 300, 405) **caractérisé en ce que** le dispositif comprend :
une couche d'électrode inférieure (220, 330, 411) comprenant de l'oxyde d'indium-étain ; et
une couche de transport de trous (260, 417) comprenant un polymère, ladite couche de transport de trous (260, 417) étant fabriquée par dépôt en phase vapeur d'un monomère de transport de trous (250) sur ledit dispositif, la couche de transport de trous polymérisée (260, 417) se formant en premier lieu sur la surface supérieure exposée de ladite couche d'électrode inférieure (220, 330, 411) et non sur la surface du substrat (310, 408) et/ou ailleurs sur les surfaces dudit dispositif.

13. Dispositif (210, 300, 405) selon la revendication 12, la couche de transport de trous (260, 417) étant formée de monomères de transport de trous (250), le monomère de transport de trous (250) étant du dibromo(3,4-éthylènedioxy)thiophène.

14. Dispositif (210, 300, 405) selon l'une des revendications 12 ou 13, la couche de transport de trous (260, 417) comprenant du poly(3,4-éthylènedioxy)thiophène.

15. Dispositif (210, 300, 405) selon l'une des revendications 12 à 14, le substrat (310, 408) comprenant du verre.

16. Dispositif (210, 300, 405) selon l'une des revendications 12 à 15, le dispositif électronique organique étant un dispositif à diode électroluminescente organique (OLED).

17. Le dispositif (210, 300, 405) selon la revendication 16 comprenant en outre :
une couche émissive (420) au-dessus de la couche de transport de trous (260, 417), ladite couche émissive (420) émettant de la lumière par recombinaison de charges.
